# EUROPEAN PATENT SPECIFICATION

(11) **EP 1 395 516 B1**
(45) Date of publication and mention of the grant of the patent: **25.10.2006**
(21) Application number: 02734428.2
(22) Date of filing: 14.05.2002
(51) Int. Cl.: B81B 3/00, H01H 1/00

(54) **Membrane for micro-electro-mechanical switch, and methods of making and using it**
Membran für Mikroelektromekanischen Schalter und Verfahren zu dessen Herstellung und Verwendung
Membrane pour interrupteur mécanique microélectrique, et ses procédés de fabrication et d'utilisation

(30) Priority: 25.05.2001 US 866205
(43) Date of publication of application: 10.03.2004
(73) Proprietor: RAYTHEON COMPANY, Lexington, Massachusetts 02421 (US)
(72) Inventor: CHEN, Shea (nmi), Plano, TX 75075 (US); PILLANS, Brandon, W., Dallas, TX 75252 (US); EHMKE, John, C., Garland, TX 75043 (US); YAO, Zhimin, Jamie, Newbury Park, CA 91320 (US)
(74) Representative: Lawrence, John
(86) International application number: PCT/US2002/015346
(87) International publication number: WO 2002/096796

(56) References cited:
- EP-A- 0 709 911
- US-A- 4 356 730
- US-A- 5 652 559
- US-A- 6 100 477
- CHAN E K ET AL: "COMPREHENSIVE STATIC CHARACTERIZATION OF VERTICAL ELECTROSTATICALLYACTUATED POLYSILICON BEAMS" IEEE DESIGN & TEST OF COMPUTERS, IEEE COMPUTERS SOCIETY. LOS ALAMITOS, US, vol. 16, no. 4, October 1999 (1999-10), pages 58-65, XP000920114 ISSN: 0740-7475

## Description

### TECHNICAL FIELD OF THE INVENTION

This invention relates in general to switches and, more particularly, to micro-electro-mechanical switches having flexible capactive membranes.

### BACKGROUND OF THE INVENTION

One existing type of switch is a radio frequency (RF) micro-electro-mechanical switch (MEMS). This existing switch has a substrate with two spaced and conductive posts thereon. A conductive part is provided on the substrate between the posts, and is covered by a layer of a dielectric material. A flexible membrane made of an electrically conductive material extends between the posts, so that a central portion thereof is above the conductive part on the substrate. The portion of the membrane extending between the posts is approximately planar in a non-flexed state. An RF signal is applied to one of the conductive part and the membrane.

In order to actuate the switch, a direct current (DC) bias voltage is applied between the membrane and the conductive part, and produces charges on the membrane and the conductive part which cause them to be electrostatically attracted to each other. This causes the membrane to flex so that a central portion thereof moves downwardly until it contacts the dielectric layer over the conductive part. This is the actuated position of the switch. In this actuated position, the RF signal traveling through one of the membrane and conductive part is capactively coupled substantially in its entirety to the other thereof. In order to deactuate the switch, the DC bias voltage is turned off. The inherent resilience of the membrane then returns the membrane to its original position.

While existing switches of this type have been generally adequate for the their intended purposes, they have not been satisfactory in all respects. One problem is that the DC bias voltage needed to flex the membrane during actuation can be relatively high, for example from 40 to 100 volts. These high bias voltages tend to introduce charge in the form of electrons into the dielectric layer, and these electrons tend to remain there. The dielectric layer then develops a permanent charge which tends to interact with the membrane so as to keep the membrane in contact with the dielectric layer, even after the bias voltage has been turned off. In other words, the switch latches in its actuated position, and cannot be deactuated. This represents a failure of the switch. Consequently, the buildup of charge in the dielectric layer, due to the use of high bias voltages, reduces the useful operational lifetime of the switch.

A related consideration is that the minimum required bias voltage tends to vary rather significantly with respect to changes in temperature. This is because the substrate and the membrane are made from different materials which have different coefficients of thermal expansion (CTE). Thus, as the ambient temperature is varied from a high temperature to a low temperature, expansion forces are exerted on the membrane at some temperatures, and contraction forces are exerted on it at other temperatures. When expansion forces are being exerted on the membrane, it increases the force needed to flex the membrane and pull it down to the actuated position, which in turn makes it necessary to use a higher bias voltage in order to effect such movement. However, as discussed above, the higher bias voltage tends to reduce the useful lifetime of the device. In order to obtain a meaningful lifetime, existing switches of this type have to be specified for use within a restricted temperature range, which is less than a desirable range for most commercial applications, and which is much less than the range required for military equipment.

A further consideration with these existing switches is that, although the bias voltage is used to flex the membrane to its actuated position, no external force acts on the membrane when the switch is deactuated. Instead, the inherent resilience of the membrane itself must be sufficient to return the membrane to its original position. As discussed above, charge buildup in the dielectric layer can tend to electrostatically attract the membrane, and thus resist movement of the membrane back to its deactuated position. One way to address this problem is to increase the resilient restoring force within the membrane itself, but a drawback is that a larger force is needed to flex the membrane to its actuated position, which in turn means that a higher bias voltage is needed for actuation of the switch. However, as discussed above, higher bias voltages increase the rate at which residual charge builds up within the dielectric layer, which in turn reduces the useful lifetime of the switch.

Still another consideration is that existing switches have relatively thin membranes, in order to give the membrane sufficient flexibility to move to its actuated position in response to the bias voltage. However, the relatively small cross-sectional area of these existing membranes results in a membrane resistance of approximately 0.5 ohms to 1.0 ohms, which is higher than ideally desirable, and which limits the amount of current that can reasonably flow through the membrane, thus limiting the amount of power which the switch can handle.

A further power consideration which limits the power handling capability of these existing switches is that a large RF current can produce a magnetic field which tends to keep the membrane in the actuated position, even after the DC bias voltage has been turned off. As noted above, it is possible to increase the resilient restoring force which urges the membrane upwardly, but this in turn creates the need to increase the bias voltage that actuates the switch, and decrease the higher bias voltage has the undesirable effect of reducing the operational lifetime of the switch.

An example of a micro-mechanical-electrical switch can be found in U.S. Patent No. 6,100,477 with a membrane that gets pulled down flat to a dielectric and bottom electrode.

### SUMMARY OF THE INVENTION

From the foregoing, it may be appreciated that a need has arisen for a method and apparatus for making and operating a switch of the type having a flexible membrane, so that the switch can be reliably operated across a wide temperature range with a significantly lower pull-in voltage than existing switches. According to one form of the present invention, a method and apparatus are provided to address this need, and utilize a switch which includes a base section, an electrically conductive part supported on the base section, and a membrane having first and second ends supported at spaced locations on the base section, the membrane having an electrically conductive portion disposed between the ends thereof. The method and apparatus involve: providing between the first and second ends of the membrane resilient structure which is capable of yieldably expanding in a direction lengthwise of the membrane so as to increase an effective length of the membrane; and responding to an applied voltage between the conductive part and the conductive portion by resiliently flexing the membrane so that the membrane moves from a first position where the membrane is unflexed and the conductive portion is spaced from the conductive part to a second position where the membrane is flexed and the conductive portion is adjacent the conductive part, the resilient structure expanding as the membrane is moved from the first position to the second position

A different form of the present invention relates to fabrication of a switch, and involves: forming an electrically conductive part on a base section; forming over the conductive part a spacer layer having a top surface with a portion that defines one of a groove and a ridge with respect to a remainder of the top surface; forming over the top surface a membrane layer which has first and second ends engaging spaced portions of the base section disposed on opposite sides of the conductive part, and which has an electrically conductive portion between the first and second ends; and removing the spacer layer so as to leave the membrane layer supported by the ends thereof with the electrically conductive portion spaced above the conductive part.

### BRIEF DESCRIPTION OF THE DRAWINGS

A better understanding of the present invention will be realized from the detailed description which follows, taken in conjunction with the accompanying drawings, in which:
FIGURE 1 is diagrammatic fragmentary sectional side view of an apparatus which includes a micro-electro-mechanical switch embodying the present invention;
FIGURE 2 is a diagrammatic fragmentary top view of the apparatus of FIGURE 1, and also diagrammatically shows a control circuit which effects operation of the switch;
FIGURE 3 is a diagrammatic fragmentary sectional side view similar to FIGURE 1, but showing a different operational position of a membrane of the switch;
FIGURE 4 is a diagrammatic fragmentary sectional side view similar to FIGUREs 1 and 3, but showing still another operational position of the membrane of the switch;
FIGURE 5 is a diagrammatic fragmentary sectional side view of the switch of FIGURE 1 at a point in time during a process of fabricating the switch;
FIGURE 6 is a diagrammatic fragmentary sectional side view similar to FIGURE 1 but showing as background to the present invention a different apparatus which includes a switch;
FIGURE 7 is a diagrammatic fragmentary sectional side view showing the apparatus of FIGURE 6 at a point in time during the fabrication of the switch;
FIGURE 8 is a diagrammatic fragmentary sectional side view similar to FIGURE 6 but showing as background to the present invention yet another apparatus which includes a switch;
FIGURE 9 is a diagram showing as background to the present invention several different types of membranes used in micro-electro-mechanical switches;
FIGUREs 10-17 are graphs which diagrammatically show various different characteristics of one or more of the membranes shown in FIGURE 9; and
FIGUREs 18 and 19 are each a diagrammatic side view of a portion of one of the membranes of FIGURE 9, showing how that membrane will respond to variations in temperature.

### DETAILED DESCRIPTION OF TEE INVENTION

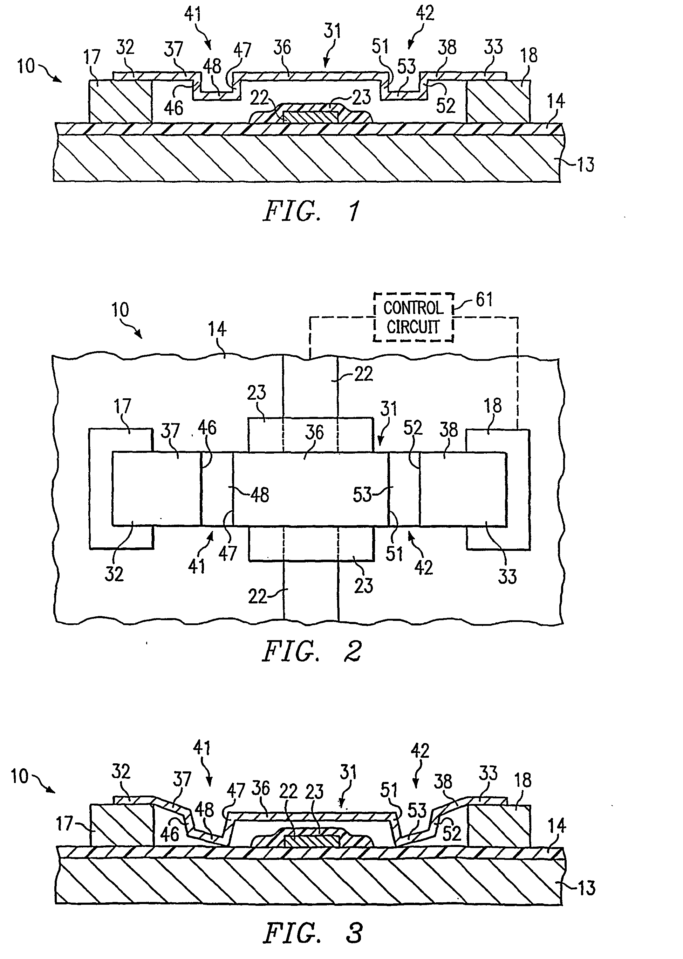

FIGURE 1 is a diagrammatic fragmentary sectional side view of an apparatus which includes a micro-electro-mechanical switch (MEMS) 10 that embodies the present invention. FIGURE 2 is a diagrammatic fragmentary, top view of the apparatus of FIGURE 1, showing the switch 10.

The switch 10 includes a silicon semiconductor substrate 13 having on an upper side thereof an oxide layer 14, which in the illustrated embodiment is silicon dioxide. Although the substrate 13 is a silicon semiconductor material in the disclosed embodiment, it could alternatively be some other suitable material, such as gallium arsenide (GaAs), or a suitable alumina. As shown in FIGURE 1, two posts 17 and 18 are provided at spaced locations on the oxide layer 14, and are each made of a conductive material such as gold. The substrate 13, the oxide layer 14 and the posts 17 and 18 can be referred to as a base section of the switch 10.

An electrically conductive electrode 22 is provided on the upper surface of the oxide layer 14, intermediate the posts 17 and 18. As seen in FIGURE 2, the electrode 22 is an elongate strip. The electrode 22 serves as a transmission line. The portion of the electrode 22 located between the posts 17 and 18 is covered by a dielectric layer 23, which is made of silicon nitride.

A conductive membrane 31 extends between the upper ends of the posts 17 and 18. The membrane 31 is made of an aluminum alloy which is known in the art, and which contains approximately 99% aluminum by weight, with most or all of the remainder being silicon and titanium. However, other suitable materials could alternatively be used for the membrane 31. The membrane 31 has ends 32 and 33, which are each fixedly supported on the top portion of a respective one of the posts 17 and 18. The membrane 31 has intermediate the ends 32 and 33 a central portion 36, which is disposed directly above the electrode 22 and the dielectric layer 23. Membrane 31 has adjacent its ends 32 and 33 respective outer portions 37 and 38. The central portion 36 and the outer portions 37 and 38 are approximately co-planar.

The membrane 31 has an expansion section 41 between the central portion 31 and the outer portion 37, and has a similar expansion section 42 between the central portion 36 and the outer portion 38. The expansion sections 41 and 42 are each approximately U-shaped. In particular, the expansion section 41 includes spaced vertical portions 46 and 47, and a horizontal portion 48 that extends between the lower ends of the vertical portions 46 and 47. In the operational position shown in FIGURE 1, the horizontal portion 48 is approximately parallel to the central portion 36 and the outer portion 37, and the vertical portions 46 and 47 are each approximately perpendicular to the horizontal portion 48, the central portion 46 and the outer portion 37. The expansion section 42 is similar, and includes vertical portions 51 and 52, and a horizontal portion 53.

The portions 48 and 53 have the same length, and the portions 46-47 and 51-52 all have the same height. The outer portions 37 and 38 have the same length. In FIGURE 1 the portions 37 and 38 each have the same length as the portions 48 and 53.

In operation, a radio frequency (RF) signal with a frequency in the range of approximately 300 MHz to 90 GHz will be traveling through one of the membrane 31 or the electrode 22 that serves as a transmission line. More specifically, the RF signal may be traveling from the post 17 through the membrane 31 to the post 18. Alternatively, with reference to FIGURE 2, the RF signal may be traveling through the electrode 22 from the lower portion of the figure toward upper portion of the figure. Actuation of the switch 10 is carried out under control of a direct current (DC) bias voltage, which is applied between the membrane 31 and the electrode 22 by a control circuit which is of a known type, and which is indicated diagrammatically at 61 in FIGURE 2 by broken lines. This bias voltage is also referred to as a pull-in voltage (Vp).

When the bias voltage is not applied to the switch 10, the membrane 31 has the position which is shown in FIGURE 1. As discussed above, an RF signal is passing through one of the membrane 31 and the electrode 22. For purposes of convenience in the discussion which follows, it will be assumed that this RF signal is passing through the electrode 22. When the membrane 31 is in the position of FIGURE 1, the RF signal traveling through the electrode 22 will pass through the switch 10 and then continue traveling through the electrode 22, with no significant coupling of this RF signal from the electrode 22 over to the membrane 31.

In order to actuate the switch 10, a DC bias voltage is applied by the control circuit 61 between the electrode 22 and the membrane 31. This voltage produces charges on the membrane 31 and on the electrode 22, which cause the central portion 36 of the membrane 31 to be urged toward the electrode 22 by an electrostatic force. This attractive force causes the membrane 31 to flex downwardly, so that its central portion 36 moves toward the electrode 22. As this occurs, the vertical portions 46 and 47 of the expansion section 41 will each tilt slightly in relation to the horizontal portion 48, so that their upper ends move away from each other. The vertical portions 51 and 52 of the expansion section 42 will experience a similar tilting movement. This results in a slight increase in the effective length of each of the expansion sections 41 and 42, which in turn results in a slight increase in the overall effective length of the membrane 31. The membrane 31 can thus move downwardly more easily than would be the case if the membrane 31 did not have the expansion sections 41 and 42.

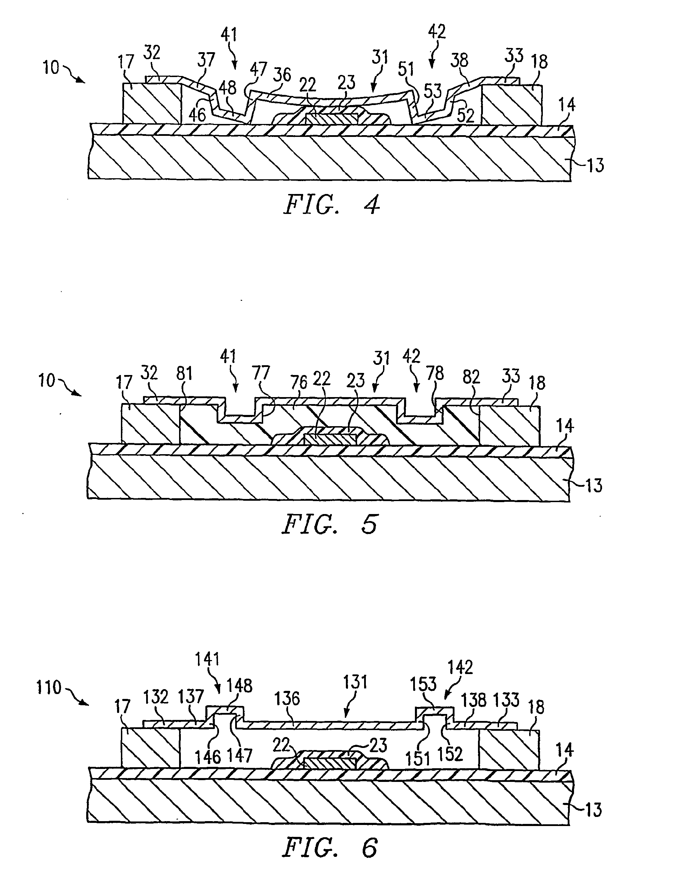

As the membrane 31 flexes downwardly, it reaches the position shown in FIGURE 3, where at least part of each horizontal section 48 and 53 engages the oxide layer 41. In this position, the central portion 36 of the membrane 31 will still be spaced a small distance above the dielectric layer 23 that covers the electrode 22. Further downward movement of the central portion 36 of the membrane 31 requires flexing of the central portion 36 itself. This additional flexing requires a higher attractive force between the central portion 36 and the electrode 22 than was needed to effect initial downward movement of the central portion 36. On the other hand, since the central portion 36 and the electrode 22 are now physically closer than they were in the operational position shown in FIGURE 1, the electrostatic attraction between them will be inherently higher than it was in the operational position of FIGURE 1. Thus, the additional force needed to effect further downward movement of the central portion 36 from the operational position of FIGURE 3 to the operational position of FIGURE 4 will occur without any need to increase the DC bias voltage that is being applied between the membrane 31 and the electrode 22.

More specifically, from the position shown in FIGURE 3, the central portion 36 of the membrane flexes until its center engages the top of the dielectric layer 23, as shown in FIGURE 4. This is the actuated position of the switch 10. In this position, the capacitive coupling between the electrode 22 and the central portion of the membrane 36 is approximately 100 times greater than when the membrane is in the deactuated position shown in FIGURE 1. Consequently, the RF signal which is traveling through the electrode 22 will be coupled substantially in its entirety from the electrode 22 over into the membrane 31, and will tend to have components which travel away from the central portion 36 in opposite directions, toward each of the posts 17 and 18. Alternatively, if the RF signal had been traveling through the membrane 31 from the post 17 to the post 18, the RF signal would have been coupled substantially in its entirety from the central portion 36 to the electrode 22, and would tend to travel away from the switch 10 in each of opposite directions through the electrode 22.

Once the membrane 31 has reached the actuated position shown in FIGURE 4, the control circuit 61 may optionally reduce the DC bias voltage to a standby or hold value, which is less than the pull-in voltage needed to initiate downward movement of the membrane 31 from the position of FIGURE 1, but which is sufficient to maintain the membrane 31 in the actuated position of FIGURE 4 once it has reached this actuated position.

In order to deactivate the switch 10, the control circuit 61 turns off the DC bias voltage which is being applied between the membrane 31 and the electrode 22. The resilience of the flexed central portion 36, in association with engagement of the adjacent expansion sections 41 and 42 with the oxide layer 14, results in a relatively strong restoring force, which initiates upward movement of the central portion 36 away from the dielectric layer 23 and the conductive part 22. Once upward movement is initiated, the membrane 31 will continue moving, and will move through the position of FIGURE 3 as it returns to the position of FIGURE 1 due to resilience within the membrane 31. In this regard, the expansion sections 41 and 42 each resiliently contract to their original shape and length.

FIGURE 5 is a diagrammatic fragmentary sectional side view of the switch 10 of FIGURE 1, showing a point in time during fabrication of the switch 10 according to a process which embodies the present invention. In more detail, fabrication begins with the silicon substrate 13, and then the oxide layer 14 is formed through deposition of silicon dioxide on the substrate 13. Then, the electrode 22 is formed on the oxide layer 14, for example by depositing a layer of gold and then carrying out a patterned etch.

Next, the dielectric layer 23 is formed, by depositing a layer of silicon nitride, and then carrying out a patterned etch. A spacer 76 is then formed over the oxide layer 14 and the dielectric layer 23. The spacer 76 is a photoresist material of a type known to those skilled in the art. The photoresist layer is then patterned and etched one or more times, in order to define spaced, transverse grooves 77 and 78 in a top surface of the spacer 76, and so as to define vertical side surfaces 81 and 82 adjacent the locations where the posts 17 and 18 will be formed. The grooves 77 and 78 each have an approximately rectangular cross section.

Next, the posts 17 and 18 are formed, by depositing a layer of gold and then carrying out a patterned etch to remove unwanted material, so as to leave just the posts 17-18. Next, a layer of the above-mentioned aluminum alloy is deposited over the spacer 76, the electrodes 17-18 and the oxide layer 14, and is then patterned and etched to form the membrane 31. At this point, the structure has the configuration shown in FIGURE 5.

Next, an etch procedure referred to as a membrane release etch is carried out in order to remove the spacer 76 in its entirety. The membrane release etch may, for example, be a plasma etch of a known type, or any other suitable etch which will attack the material of the photoresist that forms the spacer 76. This etch leaves the membrane 31 suspended on the posts 17-18 by its ends 32 and 33. This is the finished configuration of the switch 10, which is shown in FIGURE 1.

FIGURE 6 is a diagrammatic fragmentary sectional side view similar to FIGURE 1, but showing as background to the invention a different switch 110 to the switch 10 of FIGURE 1. In this regard, the switch 110 is generally similar to the switch 10 of FIGURE 1, except that the switch 110 has a membrane 131 which is different from the membrane 31 of the switch 10. Other structure within FIGURE 6 is identified by the same reference numerals used in FIGURE 1.

The membrane 131 of FIGURE 6 is made from the same material as the membrane 31 of FIGURE 1. It includes ends 132 and 133 which are each fixedly supported on a respective one of the posts 17 and 18. The membrane 131 has a central portion 136, and two outer portions 137 and 138 that are each adjacent a respective one of the ends 132-133. The membrane 31 has a substantially U-shaped expansion section 141 between the central portion 136 and the outer portion 137, and a further substantially U-shaped expansion section 142 between the central portion 136 and the outer portion 132. The central portion 136 and the outer portions 137 and 138 are approximately co-planar with each other when the membrane 131 is not flexed. One difference between the membrane 131 of FIGURE 6 and the membrane 31 of FIGURE 1 is that the expansion sections 41 and 42 of the membrane 31 project downwardly with respect to the central portion 36 thereof, whereas the expansion sections 141 and 142 of the membrane 131 project upwardly with respect to the central portion 136 thereof.

More specifically, the expansion section 141 includes two spaced vertical portions 146 and 147 which are each perpendicular to and extend upwardly from a respective one of the central portion 136 and the outer portion 137. The expansion section 141 further includes a horizontal portion 148 which is perpendicular to and extends between the upper ends of the vertical portions 146 and 147. Similarly, the expansion section 142 includes vertical portions 151 and 152 which each extend perpendicular to and upwardly from an end of a respective one of the central portion 136 and the outer portion 138, and includes a horizontal portion 153 which is perpendicular to and extends between the upper ends of the vertical portions 151-152.

The operation of the switch 110 of FIGURE 6 is generally similar to the operation of the switch 10 of FIGURE 1, except as discussed below. More specifically, as the membrane 131 flexes downwardly during actuation of the switch 110, it should be evident that the expansion sections 141 and 142 will not engage the oxide layer 14. Thus, the membrane 131 will simply carry out a generally progressive flexing movement from the position shown in FIGURE 6 to a position in which the middle of the central portion 136 is engaging the top of the dielectric layer 23. Also, when the DC bias voltage supplied to the switch 110 is terminated, in order to deactuate the switch, the restoring force which initiates upward movement of the membrane 131 back to the position shown in FIGURE 6 is effected by inherent resilience throughout the portion of the membrane 131 located between the electrodes 17-18.

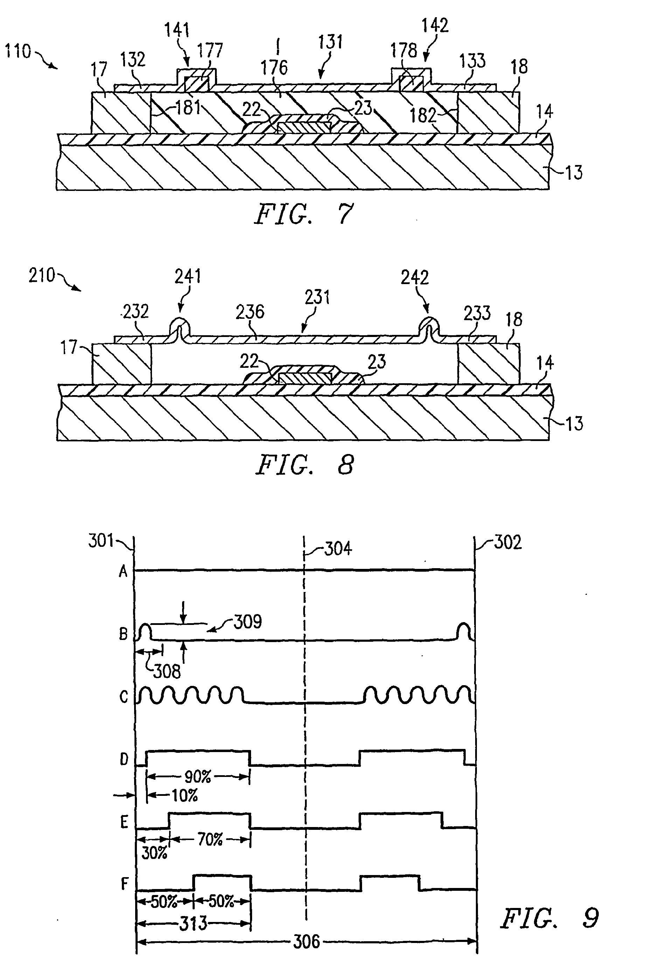

FIGURE 7 is a diagrammatic fragmentary sectional side view of the switch 110, showing a point in time during fabrication of the switch 110 according to a process which embodies the present invention. In this regard, the substrate 13, the oxide layer 14, the electrode 22 and the dielectric layer 23 are all formed in a manner similar to that described above in association with FIGURE 5. Then, a spacer layer 176 is formed from a known photoresist or polyimide material, and is patterned and etched to an appropriate shape, including formation of side surfaces 181-182. Then, a further layer of the same or an equivalent material is deposited on the spacer 176, and is patterned and etched to form spaced and parallel ridges or spacers 177 and 178.

Then, the membrane 131 is fabricated in a manner similar to that explained above with respect to formation of the membrane 31 shown in FIGURE 5. This results in the structure shown in FIGURE 7. Then, a plasma etch or other suitable technique is used to remove the photoresist material which serves as the spacer 176 and the spacers 177 and 178, thereby leaving the switch 110 in its final configuration, as shown in FIGURE 6.

FIGURE 8 is a diagrammatic fragmentary sectional side view similar to FIGURE 6, but showing as background to the invention a different switch 210 to the switch 110 of FIGURE 6. The primary difference between the switch 210 of FIGURE 8 and the switch 110 of FIGURE 6 is that the switch 210 has a membrane 231 which is different from the membrane 131 of FIGURE 6. The remaining portions of the switch 210 are equivalent to the corresponding portions of the switch 10 of FIGURE 1 and the switch 110 of FIGURE 6, and are identified with the same reference numerals.

Membrane 231 of FIGURE 8 has ends 232 and 233 which are each fixedly supported on a respective one of the posts 17-18. Further, the membrane 231 has a central portion 236, with expansion sections 241 and 242 on opposite sides thereof. The primary difference between the membrane 231 of FIGURE 8 and the membrane 131 of FIGURE 6 is that the expansion sections 141 and 142 of the membrane 131 have a shape which is approximately a square wave or rectangle, whereas the expansion sections 241-242 of the membrane 231 each have a shape which is one period of a sine wave, from one negative peak of the sine wave to the next negative peak. The expansion sections 241-242 each project upwardly with respect to the central portion 236. The operation of the switch 210 of FIGURE 8 is generally similar to the operation of the switch 110 of FIGURE 5, and it is therefore believed to be unnecessary to provide a separate detailed explanation of how the switch 210 operates.

FIGURE 9 is a diagram which shows, as background to the invention, six diagrammatic membranes A-F, each extending between electrodes that are represented diagrammatically at 301 and 302. This is not a single switch with six membranes, but six membranes drawn from six different switches and depicted together for comparative purposes. It will be recognized that the membrane B is similar to the membrane 231 of FIGURE 8, and the membrane F is similar to the membrane 131 of FIGURE 6. The membranes D and E are variations of the membrane 31 of FIGURE 6. The membrane A in FIGURE 9 is a membrane of a preexisting type which is known in the art, and which is included in FIGURE 9 to provide a point of reference against which to evaluate the other membranes. The centers of the membranes A-F are at locations that correspond to the broken line 304.

For purposes of the discussion which follows, some exemplary dimensions will be set forth in association with the membranes of FIGURE 9, but it will be recognized that these dimensions are for illustrative purposes, and are not intended to suggest that the present invention is limited in any way to these specific dimensions. In this regard, it is assumed that the distance 306 between the electrodes 301-302 is 300 to 320 microns. Further, it is assumed that the membranes A-F each have a thickness of 0.3 microns. It is assumed that the switches in which the membranes A-F are installed are identical except for the membranes, and that each such switch has a dielectric layer with a thickness of approximately 0.1 microns, and a spacing between the membrane and dielectric of 4 microns when the switch is deactuated.

Focusing on the membrane B, the spaced expansion sections include a single period of a sine wave at each end, which has a period 308 of approximately 15 microns, and an amplitude 309 of approximately 3 microns. The expansion sections of the membrane B are each positioned closely adjacent one of the posts 301 and 302.

Turning to the membrane C, this membrane is generally similar to the membrane B, except that the expansion section at each end includes five periods of a sine wave rather than just one period, these periods collectively adding up to a distance 313 which is approximately 100 microns. These sine waves each have the same amplitude as the waves in the membrane B, or in other words an amplitude of 3 microns.

The membranes D, E, and F are each a variation of the membrane 131 of FIGURE 6, where the ratio of the length of the expansion section to the adjacent outer portion is varied. In this regard, the outer portions of the membrane D each have a length of approximately 10 microns, and the expansion sections each have a length of approximately 90 microns. The outer portions of the membrane E each have a length of approximately 30 microns, and the expansion sections thereof each have a length of approximately 70 microns. The outer portions of membrane F each have a length of approximately 50 microns, and the expansion sections thereof each of a length of approximately 50 microns.

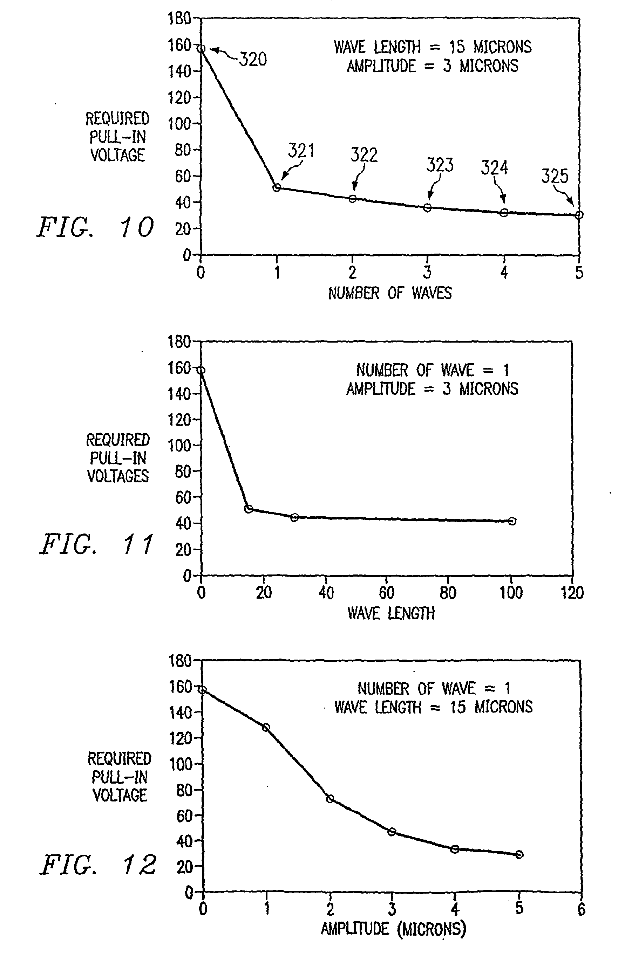

FIGURE 10 is a graph showing how the pull-in voltage needed for switch actuation will vary as the number of waves in the expansion sections of the membrane is varied. In this regard, point 320 represents the membrane A of FIGURE 9, which has no expansion sections or waves. Point 321 represents the membrane B of FIGURE 9, which has one sine wave in each expansion section. Points 322-324 represent variations of the membrane B, which are not separately illustrated in FIGURE 9, and which respectively have two, three and four sine waves in each expansion section. Point 325 in FIGURE 10 represents the membrane C of FIGURE 9, which has five sine waves in each expansion section.

Based on a comparison of points 320 and 321, it will be noted that providing spaced expansion sections with one sine wave effects a substantial reduction of about 70% in the pull-in voltage needed to actuate the switch. With reference to points 322-325, adding additional sine waves to the expansion sections provides still better performance, but with a diminishing marginal effect.

FIGURE 11 is a further graph corresponding specifically to the membrane B of FIGURE 9, and showing how the pull-in voltage varies in response to variation of the wavelength or period, or in other words variation of the distance 308 in FIGURE 9. It will be noted that there is a significant decrease in the pull-in voltage when the wavelength is less than about 10 times the amplitude, but limited additional benefit as the wavelength is increased beyond 10 times the amplitude.

FIGURE 12 is a graph which also corresponds to the membrane B of FIGURE 9, and shows how the required pull-in voltage varies as the amplitude 309 is varied. It will be noted that the pull-in voltage is significantly reduced as the amplitude is increased until the amplitude is approximately 20% to 25% of the wavelength or period 308. Additional increases in the amplitude provide limited additional benefit.

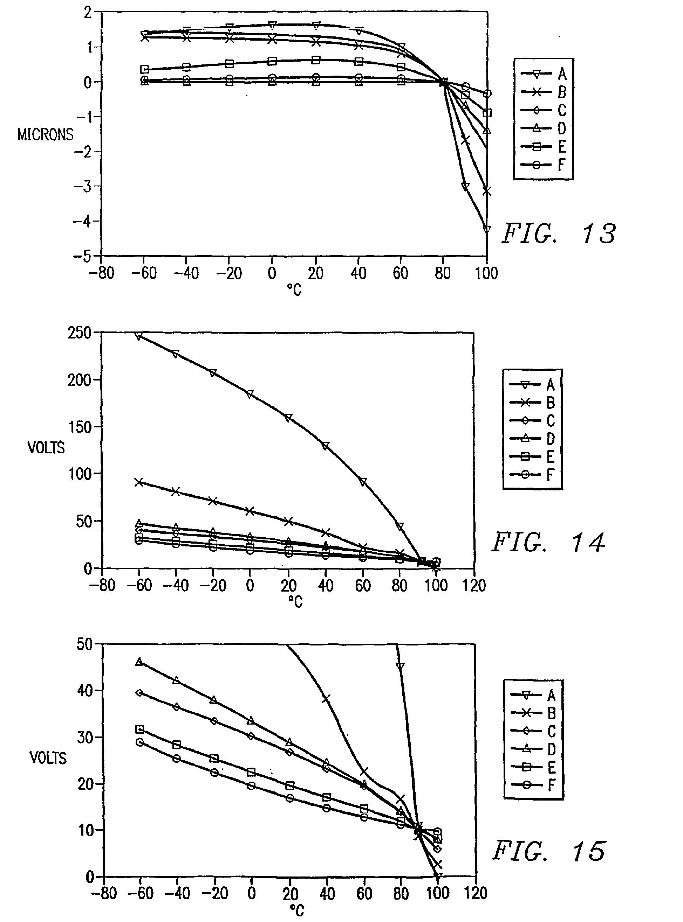

FIGURE 13 is a graph showing six curves, each of which corresponds to a respective one of the membranes A-F of FIGURE 9. In effect, these curves each show the extent to which the associated membrane would tend to droop in response to variations in temperature. It will be noted that, at higher temperatures, the membranes D-F tend to experience less droop than the membranes A-C.

FIGUREs 14 and 15 are related graphs which each show six curves corresponding respectively to the six membranes A-F of FIGURE 9, FIGURE 15 being a view of the lower portion FIGURE 14 with an enlarged vertical scale. The graphs of FIGUREs 14 and 15 each show how the pull-in voltage needed for actuation will tend to vary over temperature. It will be noted that the membranes C-F can be actuated throughout the indicated temperature range by a pull-in voltage which is significantly less than that required for either of the membranes A and B.

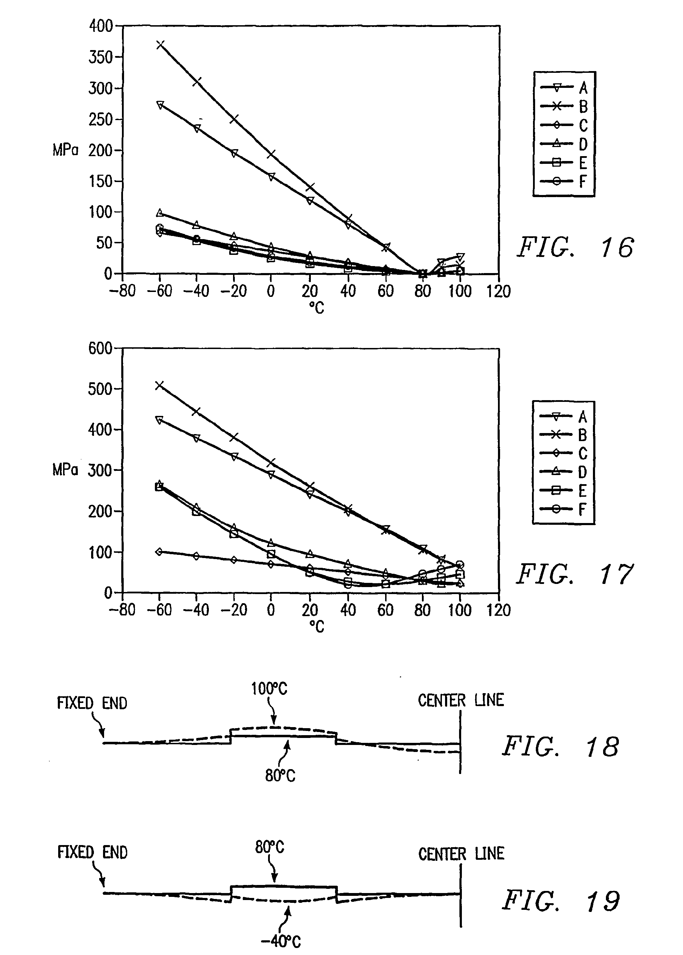

FIGURE 16 is a graph showing six lines that each correspond to a respective one of the six membranes A-F in FIGURE 9. FIGURE 16 shows the stress which occurs within each membrane at different temperatures, when the membrane is in its deactuated position. It will be noted that the membranes C-F all experience substantially less stress than the membranes A and B.

FIGURE 17 is a graph showing six lines which each correspond to a respective one of the six membranes A-F of FIGURE 9. FIGURE 17 shows how the tensile stress within each membrane varies with temperature when the membrane is in its actuated position, or in other words its flexed position. It will be noted that the most stress occurs at low temperatures, that the membrane C experiences substantially less internal stress at low temperatures than the membranes D-F, and that all of the membranes C-F experience less stress than either of the membranes A and B.

FIGUREs 18 and 19 are similar diagrammatic views showing the left half of the membrane F of FIGURE 9, at selected temperatures. FIGUREs 18 and 19 are each based on the assumption that the membrane is fabricated in a manner so that it has no thermal deformation at a temperature of 80°C. FIGURE 18 shows the nature of the deformation that the membrane will experience as it is heated from 80°C to 100°C. FIGURE 19 shows the deformation which the membrane will experience as it is cooled from 80°C to -40°C. It will be noted from the right side of FIGURE 19 that the central portion of the membrane does not experience substantial deformation or move upwardly or downwardly as the ambient temperature is varied across the 120°C temperature range from -40°C to 80°C. In contrast, it will be noted from the right side of FIGURE 18 that the central portion of the membrane experiences some deformation and moves downwardly a small distance when the membrane has been heated to 100 C.

In effect, FIGUREs 18 and 19 are showing the manner in which the membrane will tend to be deformed as a result of the different coefficients of thermal expansion (CTE) of the membrane and the associated substrate. Tilting of the vertical portions of the membrane provide compensation across the 120°C temperature range for the CTE mismatch between the membrane and the substrate, while avoiding deformation of the central portion of the membrane.

The present invention provides a number of technical advantages. One such technical advantage results from the provision in a membrane of resilient structure such as spaced expansion sections that are capable of yieldably expanding in a direction lengthwise of the membrane, so as to increase an effective length of the membrane and thereby facilitate resilient flexing of the membrane between positions corresponding to actuated and unactuated states of a switch. This reduces the pull-in voltage needed to actuate the switch.

A further technical advantage results from configuration of the expansion sections to include first and second portions that are approximately vertical and parallel, and a third portion which extends between the first and second portions approximately perpendicular thereto. The first and second portions can tilt to some extent so as to facilitate either expansion or contraction of the effective length of the membrane, in order to compensate for a mismatch in the CTEs of the membrane and the substrate. By compensating for the CTE mismatch, a reduction is realized in the extent to which the pull-in voltage varies over temperature. The switch can thus operate over a wider temperature range with a lower pull-in voltage than existing switches.

In one form of the present invention, the expansion sections project downwardly toward the base section relative to the rest of the membrane. As a result, these expansion sections engage the base section before the central portion of the membrane engages the dielectric layer over the electrode. The central portion then flexes until it engages the dielectric layer. One advantage of this approach is that, whenever the DC bias voltage is terminated to effect deactuation of the switch, a significant upward force is exerted on the central portion of the membrane so as to initiate its movement away from the dielectric layer and electrode. This significantly decreases the likelihood that residual charge in the dielectric layer will create an electrostatic attraction which can maintain the membrane in its actuated position even after the DC bias voltage has been turned off. A related advantage with this arrangement is that the increased restoring force is achieved without requiring an increased pull-in voltage to move the membrane from its deactuated position to its actuated position.

Still another advantage is that the provision of expansion sections permits the membrane to be somewhat thicker than would be the case with a pre-existing membrane having no expansion sections. The thicker membrane lowers the effective resistance of the membrane, which in turn permits the switch to operate at a higher power level.

## Claims

1. An apparatus comprising a switch (10), the switch including:
a base section (13, 14, 17, 18);
an electrically conductive part (22) supported on said base section;
an electrically conductive membrane (31) which has first (32) and second ends (33) supported at spaced first and second locations on said base section (13, 14, 17, 18), said membrane (31) having a central portion (36) disposed between said first (32) and second (33) ends thereof, said membrane (31) having first (41) and second (42) sections disposed on opposite sides of said central portion (36), each of said first (41) and second sections (42) extending transversely of said membrane (31) and having an approximately U-shaped profile, said conductive part (22) being positioned between said first (41) and second (42) sections, said membrane (31) capable of resiliently flexing so that said membrane (31) can move from a first position where said membrane (31) is substantially unflexed and said central portion (36) is spaced from said conductive part (22) to a second position where said membrane (31) is flexed and said central portion (36) is adjacent said conductive part (22) ;
wherein said first and second sections engage said base section before said central portion (36) reaches said position adjacent said conductive part (22) as said membrane (31) moves from said first position to said second position, and wherein said central portion (36) flexes to effect movement of said central portion (36) to said position adjacent said conductive part (22).

2. An apparatus according to Claim 1, including a dielectric layer (23) disposed over said conductive part (22), said central portion (36) of said membrane (31) engaging a side of said dielectric layer (23) opposite from said conductive part (22) when said membrane is in said second position.

3. An apparatus according to Claim 1 or claim 2, wherein said first (41) and second sections (42) are flexible and capable of yieldably varying in size in a direction lengthwise of said membrane (31) in a manner so as to vary an effective length of said membrane (31).

4. An apparatus according to any foregoing claim, wherein, when said membrane is in said first position, said U-shaped profile of each of said first (41) and second (42) sections has approximately the shape of a half period of a sine wave.

5. An apparatus according to any of claims 1 to 3 wherein when said membrane is in said first position, said U-shaped profile of each of said first (41) and second (42) sections includes spaced first (46) and second (47) portions which are approximately straight and extend approximately parallel to each other, said U-shaped profile further includes a third portion (48) which is approximately straight and extends between ends of said first (46) and second (47) portions approximately perpendicular thereto.

6. An apparatus according to Claim 5, wherein said first (46) and second (47) portions of each of said first (41) and second sections (42) tilt with respect to said third portion (48) thereof in response to exertion on said membrane (31) of one of a lengthwise contraction force and a lengthwise expansion force.

7. An apparatus according to Claim 5, wherein said first (46) and second portions (47) of each of said first (41) and second (42) sections extend from opposite ends of said third portion (48) thereof in a direction toward said base section.

8. An apparatus according to Claim 1, wherein the U-shaped profile includes multiple periods of a sine wave.

9. An apparatus according to any foregoing claim wherein said membrane has outer portions which each extend outwardly from a respective one of said first and second sections on a side thereof opposite from said central portion, said central portion and said outer portions being approximately co-planar when said membrane (31) is in said first position.

10. An apparatus according to any foregoing claim wherein said U-shaped profile approximates a rectangle.

11. An apparatus according to Claim 1, wherein said base section includes a substrate (13) having two conductive posts (17, 18) projecting upwardly from spaced said first and second locations thereon, said conductive part (22) being intermediate said posts (17, 18), said first (32) and second ends (33) of said membrane (31) being supported on a respective said post (17, 18).

12. An apparatus according to Claim 2, including a circuit (61) operable for applying between said electrically conductive part (22) and said membrane (31) a first voltage which effects movement of said membrane (31) from said first position to said second position; said circuit (61) operable for thereafter applying between said electrically conductive part (22) and said membrane (31) a second voltage which is less than said first voltage and which is sufficient to maintain said membrane (31) in said second position thereof.

13. A method of switching through use of a switch (10) which includes a base section (13, 14, 17,18), an electrically conductive part (22) supported on said base section, and an electrically conductive membrane (31) having first (32) and second (33) ends supported at spaced locations on said base section (13, 14, 17, 18), and having a central portion (36) disposed between said first (32) and second (33) ends thereof, comprising the steps of:
configuring said membrane (31) to include first (41) and second sections (42) disposed on opposite sides of said central portion (36), each of said first (41) and second sections (42) extending transversely of said membrane (31) and having an approximately U-shaped profile, said conductive part (22) being positioned between said first (41) and second (42) sections;
applying a voltage between said conductive part (22) and said central portion (36), the voltage operable to:
resiliently flex said membrane (31) so that said membrane (31) moves from a first position where said membrane (31) is unflexed and said central portion (36) is spaced from said conductive part (22) to a second position where said membrane (31) is flexed and said central portion (36) is adjacent said conductive part (22) in response to said voltage; and
cause said first and second sections to engage said base section before said central portion (36) reaches said position adjacent said conductive part (22) as said membrane (31) moves from said first position to said second position.

14. A method according to Claim 13, including the step of configuring each of said first (41) and second (42) sections to have a U-shaped profile in the shape of a half period of a sine wave.

15. A method according to Claim 13, including the step of configuring each of said first (41) and second (42) sections so that, when said membrane (31) is in said first position, said U-shaped profile thereof includes spaced first (46) and second portions (47) which are approximately straight and extend approximately parallel to each other, said U-shaped profile further includes a third portion (48) which is approximately straight and extends between ends of said first (46) and second (47) portions approximately perpendicular thereto.

16. A method according to Claim 15, including the step of causing each of said first (46) and second (47) portions of each of said first (46) and second (47) sections to tilt with respect to said third portion (48) thereof in response to the application to said membrane (31) of one of a lengthwise expansion force and a lengthwise contraction force.

17. A method according to Claim 13, including the steps of:
flexing a central portion of said membrane (31) disposed between said first (41) and second (42) sections thereof to effect movement of said central portion (36) to said position adjacent said conductive part (22).

18. A method according to claim 13, including the step of :
configuring said switch to include a dielectric layer disposed over said conductive part, said central portion of said membrane engaging a side of said dielectric layer opposite from said conductive part when said membrane is in said second position.

19. A method according to Claim 13, including the steps of:
effecting application of said applied voltage between said electrically conductive part (22) and said central portion (36) by applying therebetween a first voltage which effects movement of said membrane (31) from said first position to said second position; and
thereafter applying therebetween a second voltage which is lower than said first voltage and which is sufficient to maintain said membrane (31) in said second position thereof.

20. A method of fabricating a switch, comprising the steps of:
forming an electrically conductive part (22) on a base section;
forming over said conductive part (22) a spacer layer having a top surface with a portion that defines a pair of grooves spaced outside of each end of the conductive part (22) with respect to a remainder of said top surface, said conductive part (22) being positioned between said pair of grooves;
forming over said top surface an electrically conductive membrane layer (31) which has first (32) and second ends (33) engaging spaced portions of said base section disposed on opposite sides of said conductive part (22), said membrane layer (31) having a central portion (36) between said first and second ends, said membrane layer (31) having first (41) and second (42) sections disposed within said pair of grooves on opposite sides of said central portion (36), each of said first (41) and second (42) sections extending transversely of said membrane (31) and has an approximately U-shaped profile; and
removing said spacer layer so as to leave said membrane layer (31) supported by said ends thereof with said central portion (36) spaced above said conductive part (22), said membrane layer (31) operable to flex to a first position where the first (41) and second (42) sections engage said base section before said central portion engages said conductive part (22).

21. A method according to Claim 20, wherein said step of forming said spacer layer is carried out by forming a first portion of said spacer layer over said conductive part, and then forming second portions of said spacer layer including said pair of grooves on said first portion thereof.

22. A method according to Claim 20, including the step of forming said base section by carrying out the steps of:
providing a substrate (13);
forming an oxide layer (14) over said substrate (13);
forming two spaced conductive posts (17, 18) at spaced locations on said oxide layer (14), said posts (17, 18) being said spaced portions of said base section which support said first (32) and second (33) ends of said membrane layer (31); and
carrying out said step of forming said conductive part (22) by forming said conductive part (22) at a location between said posts (17, 18).

## Patentansprüche

1. Vorrichtung, umfassend einen Schalter (10), wobei der Schalter enthält:
einen Basisabschnitt (13, 14, 17, 18);
einen elektrisch leitfähigen Teil (22), der von dem Basisabschnitt getragen wird;
eine elektrisch leitfähige Membran (31), deren erstes (32) und zweites Ende (33) sich an beabstandeten ersten und zweiten Stellen auf dem Basisabschnitt (13, 14, 17, 18) abstützen, wobei die Membran (31) einen Mittelteil (36) hat, der zwischen ihrem ersten (32) und zweiten (33) Ende angeordnet ist, wobei die Membran (31) einen ersten (41) und einen zweiten (42) Abschnitt hat, die an einander gegenüberliegenden Seiten des Mittelteils (36) angeordnet sind, wobei der erste (41) und der zweite Abschnitt (42) jeweils quer zu der Membran (31) verlaufen und ein annähernd U-förmiges Profil haben, wobei der leitfähige Teil (22) zwischen dem ersten (41) und dem zweiten (42) Abschnitt positioniert ist, wobei die Membran (31) in der Lage ist, sich elastisch zu biegen, so dass sich die Membran (31) aus einer ersten Position, in der die Membran (31) im wesentlichen nicht gebogen ist und der Mittelteil (36) von dem leitfähigen Teil (22) beabstandet ist, in eine zweite Position, in der die Membran (31) gebogen ist und der Mittelteil (36) dem leitfähigen Teil (22) unmittelbar benachbart ist, bewegen kann;
wobei der erste und der zweite Abschnitt mit dem Basisabschnitt in Eingriff kommen, bevor der Mittelteil (36) die dem leitfähigen Teil (22) unmittelbar benachbarte Position erreicht, wenn sich die Membran (31) aus der ersten Position in die zweite Position bewegt, und wobei der Mittelteil (36) sich durchbiegt, wodurch eine Bewegung des Mittelteils (36) in die dem leitfähigen Teil (22) unmittelbar benachbarte Position bewirkt wird.

2. Vorrichtung nach Anspruch 1, enthaltend eine dielektrische Schicht (23), die über dem leitfähigen Teil (22) angeordnet ist, wobei der Mittelteil (36) der Membran (31) auf einer Seite der dielektrischen Schicht (23) in Eingriff kommt, die dem leitfähigen Teil (22) gegenüberliegt, wenn die Membran in der zweiten Position ist.

3. Vorrichtung nach Anspruch 1 oder Anspruch 2, bei welcher der erste (41) und der zweite Abschnitt (42) biegsam sind und in der Lage sind, ihre Größe in einer Längsrichtung der Membran (31) in der Weise nachgiebig zu verändern, dass sich eine wirksame Länge der Membran (31) verändert.

4. Vorrichtung nach einem der vorstehenden Ansprüche, bei welcher dann, wenn die Membran in der ersten Position ist, das U-förmige Profil des ersten (41) und des zweiten (42) Abschnitts jeweils annähernd die Form einer Halbperiode einer Sinuswelle hat.

5. Vorrichtung nach einem der Ansprüche 1 bis 3, bei welcher dann, wenn die Membran in der ersten Position ist, das U-förmige Profil des ersten (41) und des zweiten (42) Abschnitts jeweils einen beabstandeten ersten (46) und zweiten (47) Teil aufweist, die annähernd gerade sind und annähernd parallel zueinander verlaufen, wobei das U-förmige Profil ferner einen dritten Teil (48) enthält, der annähernd gerade ist und zwischen den Enden des ersten (46) und des zweiten (47) Teiles annähernd senkrecht zu diesen verläuft

6. Vorrichtung nach Anspruch 5, bei welcher der erste (46) und der zweite (47) Teil jeweils des ersten (41) und des zweiten Abschnitts (42) ansprechend auf das Ausüben entweder einer Kontraktionskraft in Längsrichtung oder einer Expansionskraft in Längsrichtung auf die Membran (31) sich relativ zu ihrem dritten Teil (48) schräg stellen.

7. Vorrichtung nach Anspruch 5, bei welcher der erste (46) und der zweite (47) Teil jeweils des ersten (41) und des zweiten (42) Abschnitts von entgegengesetzten Enden ihres dritten Teiles (48) aus in einer Richtung zu dem Basisabschnitt hin verlaufen.

8. Vorrichtung nach Anspruch 1, bei welcher das U-förmige Profil mehrere Perioden einer Sinuswelle umfasst.

9. Vorrichtung nach einem der vorstehenden Ansprüche, bei welcher die Membran äußere Teile hat, die jeweils von dem jeweiligen ersten und zweiten Abschnitt an einer dem Mittelteil entgegengesetzten Seite derselben nach außen verlaufen, wobei der Mittelteil und die äußeren Teile annähernd in einer Ebene liegen, wenn die Membran (31) in der ersten Position ist.

10. Vorrichtung nach einem der vorstehenden Ansprüche, bei welcher das U-förmige Profil einem Rechteck angenähert ist.

11. Vorrichtung nach Anspruch 1, bei welcher der Basisabschnitt ein Substrat (13) enthält, das zwei leitfähige Sockel (17, 18) hat, die von der ersten und der zweiten beabstandeten Stelle darauf nach oben ragen, wobei der leitfähige Teil (22) zwischen den Sockeln (17, 18) liegt und das erste (32) und das zweite (33) Ende der Membran (31) jeweils von einem Sockel (17, 18) getragen werden.

12. Vorrichtung nach Anspruch 2, enthaltend eine Schaltung (61), die so betätigbar ist, dass sie zwischen dem elektrisch leitfähigen Teil (22) und der Membran (31) eine erste Spannung anlegt, die eine Bewegung der Membran (31) aus der ersten Position in die zweite Position bewirkt; wobei die Schaltung (61) so betätigbar ist, dass sie anschließend zwischen dem elektrisch leitfähigen Teil (22) und der Membran (31) eine zweite Spannung anlegt, die kleiner als die erste Spannung ist und die ausreicht, um die Membran (31) in ihrer zweiten Position zu halten.

13. Verfahren zum Schalten durch die Verwendung eines Schalters (10), der einen Basisabschnitt (13, 14, 17, 18), einen auf dem Basisabschnitt getragenen elektrisch leitfähigen Teil (22) und eine elektrisch leitfähige Membran (31) enthält, die ein erstes (32) und ein zweites (33) Ende, die an beabstandeten Stellen auf dem Basisabschnitt (13, 14, 17, 18) abgestützt sind, und einen zwischen ihrem ersten (32) und zweiten (33) Ende angeordneten Mittelteil (36) hat, enthaltend die Schritte:
Konfigurieren der Membran (31) in der Weise, dass sie an einander gegenüberliegenden Seiten des Mittelteils (36) angeordnet einen ersten (41) und einen zweiten Abschnitt (42) enthält, wobei der erste (41) und der zweite Abschnitt (42) jeweils in Querrichtung zu der Membran (31) verlaufen und ein annähernd U-förmiges Profil haben, wobei der leitfähige Teil (22) zwischen dem ersten (41) und dem zweiten (42) Abschnitt positioniert ist;
Anlegen einer Spannung zwischen dem leitfähigen Teil (22) und dem Mittelteil (36), wobei die Spannung so betätigbar ist, dass:
die Membran (31) elastisch gebogen wird, so dass sich die Membran (31), als Reaktion auf die Spannung, aus einer ersten Position, in der die Membran (31) nicht gebogen ist und der Mittelteil (36) von dem leitfähigen Teil (22) beabstandet ist, in eine zweite Position bewegt, in der die Membran (31) gebogen ist und der Mittelteil (36) dem leitfähigen Teil (22) unmittelbar benachbart ist; und
der erste und der zweite Abschnitt veranlasst werden, mit dem Basisabschnitt in Eingriff zu kommen, bevor der Mittelteil (36) die Position in unmittelbarer Nähe des leitfähigen Teiles (22) erreicht, wenn sich die Membran (31) aus der ersten Position in die zweite Position bewegt.

14. Verfahren nach Anspruch 13, enthaltend den Schritt des Konfigurierens des ersten (41) und des zweiten (42) Abschnitts jeweils in der Weise, dass sie ein U-förmiges Profil in der Form einer Halbperiode einer Sinuswelle haben.

15. Verfahren nach Anspruch 13, enthaltend den Schritt des Konfigurierens des ersten (41) und des zweiten (42) Abschnitts jeweils in der Weise, dass dann, wenn die Membran (31) in der ersten Position ist, ihr U-förmiges Profil beabstandet einen ersten (46) und einen zweiten (47) Teil enthält, die annähernd gerade sind und annähernd parallel zueinander verlaufen, wobei das U-förmige Profil ferner einen dritten Teil (48) enthält, der annähernd gerade ist und zwischen den Enden des ersten (46) und des zweiten (47) Teiles annähernd senkrecht zu diesen verläuft.

16. Verfahren nach Anspruch 15, enthaltend den Schritt des Veranlassens, dass der erste (46) und der zweite (47) Teil jeweils des ersten (41) und des zweiten (42) Abschnitts sich ansprechend auf das Anlegen entweder einer Expansionskraft in Längsrichtung oder einer Kontraktionskraft in Längsrichtung an die Membran (31) relativ zu ihrem dritten Teil (48) schräg stellen.

17. Verfahren nach Anspruch 13, enthaltend die Schritte:
Biegen eines Mittelteils der Membran (31), der zwischen ihrem ersten (41) und zweiten (42) Abschnitt angeordnet ist, um eine Bewegung des Mittelteils (36) in die Position in unmittelbarer Nähe des leitfähigen Teiles (22) zu bewirken.

18. Verfahren nach Anspruch 13, enthaltend den Schritt:
Konfigurieren des Schalters in der Weise, dass er eine über dem leitfähigen Teil angeordnete dielektrische Schicht enthält, wobei der Mittelteil der Membran mit einer Seite der dielektrischen Schicht in Eingriff kommt, die dem leitfähigen Teil entgegengesetzt ist, wenn die Membran in der zweiten Position ist.

19. Verfahren nach Anspruch 13, enthaltend die Schritte:
Bewirken des Anlegens der angelegten Spannung zwischen dem elektrisch leitfähigen Teil (22) und dem Mittelteil (36), indem zwischen diesen eine erste Spannung angelegt wird, die die Bewegung der Membran (31) aus der ersten Position in die zweite Position bewirkt; und
anschließend Anlegen einer zweiten Spannung zwischen diesen, die niedriger ist als die erste Spannung und die ausreichend ist, um die Membran (31) in ihrer zweiten Position zu halten.

20. Verfahren zur Herstellung eines Schalters, enthaltend die Schritte:
Bilden eines elektrisch leitfähigen Teiles (22) auf einem Basisabschnitt;
Bilden einer Abstandsschicht über dem leitfähigen Teil (22), die eine obere Oberfläche mit einem Teil hat, der ein Paar Nuten bildet, die außerhalb jedes Endes des leitfähigen Teiles (22) relativ zu einem Rest der oberen Oberfläche beabstandet sind, welcher leitfähige Teil (22) zwischen dem Paar Nuten positioniert ist;
Bilden einer elektrisch leitfähigen Membranschicht (31) über der oberen Oberfläche, die ein erstes (32) und ein zweites Ende (33) hat, welche mit beabstandeten Teilen des Basisabschnitts, die an entgegengesetzten Seiten des leitfähigen Teiles (22) angeordnet sind, in Eingriff stehen, welche Membranschicht (31) einen Mittelteil (36) zwischen dem ersten und dem zweiten Ende hat, welche Membranschicht (31) einen ersten (41) und einen zweiten (42) Abschnitt hat, die innerhalb des Nutenpaares an entgegengesetzten Seiten des Mittelteils (36) angeordnet sind, wobei der erste (41) und der zweite (42) Abschnitt jeweils in Querrichtung zu der Membran (31) verlaufen und ein annähernd U-förmiges Profil haben; und
Entfernen der Abstandsschicht, um so die Membranschicht (31) auf ihre Enden gestützt zu belassen, wobei der Mittelteil (36) über dem leitfähigen Teil (23) beabstandet ist, welche Membranschicht (31) so betätigbar ist, dass sie sich in eine erste Position biegt, in der der erste (41) und der zweite (42) Abschnitt mit dem Basisabschnitt in Eingriff kommen, bevor der Mittelteil mit dem leitfähigen Teil (42) in Eingriff kommt.

21. Verfahren nach Anspruch 20, bei welchem der Schritt des Bildens der Abstandsschicht durch das Bilden eines ersten Teils der Abstandsschicht über dem leitfähigen Teil und das anschließende Bilden von zweiten Teilen der Abstandsschicht, die das Paar Nuten enthalten, auf ihrem ersten Teil durchgeführt wird.

22. Verfahren nach Anspruch 20, enthaltend den Schritt des Bildens des Basisabschnitts durch Durchführen der Schritte:
Bereitstellen eines Substrats (13);
Bilden einer Oxidschicht (14) über dem Substrat (13);
Bilden von zwei beabstandeten leitfähigen Sockeln (17, 18) an beabstandeten Stellen auf der Oxidschicht (14), welche Sockel (17, 18) die beabstandeten Teile des Basisabschnitts sind, die das erste (32) und das zweite (33) Ende der Membranschicht (31) tragen; und
Durchführen des Schrittes des Bildens des leitfähigen Teiles (22), indem der leitfähige Teil (23) an einer Stelle zwischen den Sockeln (17, 18) gebildet wird.

## Revendications

1. Dispositif comprenant un interrupteur (10), l'interrupteur comprenant :
une section de base (13, 14, 17, 18) ;
un élément électriquement conducteur (22) supporté sur ladite section de base ;
une membrane électriquement conductrice (31) qui a des première (32) et seconde (33) extrémités supportées au niveau de premier et second emplacements espacés sur ladite section de base (13, 14, 17, 18), ladite membrane (31) ayant une partie centrale (36) disposée entre lesdites première (32) et seconde (33) extrémités de celle-ci, ladite membrane (31) ayant des première (41) et seconde (42) sections disposées sur des côtés opposés de ladite partie centrale (36), chacune desdites première (41) et seconde (42) sections s'étendant transversalement à ladite membrane (31) et ayant un profil approximativement en forme de U, ledit élément conducteur (22) étant positionné entre lesdites première (41) et seconde (42) sections, ladite membrane (31) pouvant fléchir de façon résiliente de telle manière que ladite membrane (31) peut se déplacer depuis une première position, dans laquelle ladite membrane (31) reste sensiblement non fléchie et ladite partie centrale (36) est espacée dudit élément conducteur (22), jusqu'à une seconde position, dans laquelle ladite membrane (31) est fléchie et ladite partie centrale (36) est adjacente audit élément conducteur (22) ;
dans lequel lesdites première et seconde sections viennent en prise avec ladite section de base avant que ladite partie centrale (36) atteigne ladite position adjacente audit élément conducteur (22) lorsque ladite membrane (31) se déplace depuis ladite première position jusqu'à ladite seconde position, et dans lequel ladite partie centrale (36) fléchit de façon à provoquer le déplacement de ladite partie centrale (36) jusqu'à ladite position adjacente audit élément conducteur (22).

2. Dispositif selon la revendication 1, comprenant une couche diélectrique (23) disposée au-dessus dudit élément conducteur (22), ladite partie centrale (36) de ladite membrane (31) venant en prise avec une face de ladite couche diélectrique (23) à l'opposé dudit élément conducteur (22) quand ladite membrane se trouve dans ladite seconde position.

3. Dispositif selon la revendication 1 ou la revendication 2, dans lequel lesdites première (41) et seconde (42) sections sont flexibles et aptes à changer de taille par déformation dans une direction longitudinale de ladite membrane (31) de manière à modifier une longueur effective de ladite membrane (31).

4. Dispositif selon l'une quelconque des revendications précédentes, dans lequel, lorsque ladite membrane se trouve dans ladite première position, ledit profil en forme de U de chacune desdites première (41) et seconde (42) sections a approximativement la forme d'une demi-période d'une onde sinusoïdale.

5. Dispositif selon l'une quelconque des revendications 1 à 3, dans lequel, lorsque ladite membrane se trouve dans ladite première position, ledit profil en forme de U de chacune desdites première (41) et seconde (42) sections comprend des première (46) et seconde (47) parties espacées qui sont approximativement droites et s'étendent approximativement parallèlement l'une à l'autre, ledit profil en forme de U comprend en outre une troisième partie (48) qui est approximativement droite et s'étend entre des extrémités desdites première (46) et seconde (47) parties approximativement perpendiculairement à celles-ci.

6. Dispositif selon la revendication 5, dans lequel lesdites première (46) et seconde (47) parties de chacune desdites première (41) et seconde (42) sections s'inclinent par rapport à ladite troisième partie (48) de celles-ci en réponse à l'exercice, sur ladite membrane (31), d'une force parmi une force de contraction longitudinale et une force d'extension longitudinale.

7. Dispositif selon la revendication 5, dans lequel lesdites première (46) et seconde (47) parties de chacune desdites première (41) et seconde (42) sections s'étendent à partir d'extrémités opposées de ladite troisième partie (48) de celles-ci en direction de ladite section de base.

8. Dispositif selon la revendication 1, dans lequel le profil en forme de U comprend plusieurs périodes d'une onde sinusoïdale.

9. Dispositif selon l'une quelconque des revendications précédentes, dans lequel ladite membrane a des parties extérieures qui s'étendent chacune vers l'extérieur depuis une section respective desdites première et seconde sections sur un côté de celles-ci à l'opposé de ladite partie centrale, ladite partie centrale et lesdites parties extérieures étant approximativement coplanaires quand ladite membrane (31) se trouve dans ladite première position.

10. Dispositif selon l'une quelconque des revendications précédentes, dans lequel ledit profil en forme de U est approximativement un rectangle.

11. Dispositif selon la revendication 1, dans lequel ladite section de base comprend un substrat (13) ayant deux montants conducteurs (17, 18) faisant saillie vers le haut à partir desdits premier et second emplacements espacés sur celle-ci, ledit élément conducteur (22) se situant entre lesdits montants (17, 18), lesdites première (32) et seconde (33) extrémités de ladite membrane (31) étant supportées sur un montant respectif (17, 18).

12. Dispositif selon la revendication 2, comprenant un circuit (61) pour appliquer, entre ledit élément électriquement conducteur (22) et ladite membrane (31), une première tension qui provoque un déplacement de ladite membrane (31) depuis ladite première position jusqu'à ladite seconde position, et pour appliquer, ensuite, entre ledit élément électriquement conducteur (22) et ladite membrane (31), une seconde tension qui est inférieure à ladite première tension et qui est suffisante pour maintenir ladite membrane (31) dans ladite seconde position de celle-ci.

13. Procédé de commutation, à l'aide d'un interrupteur (10) qui comprend une section de base (13, 14, 17, 18), d'un élément électriquement conducteur (22) supporté sur ladite section de base et d'une membrane électriquement conductrice (31) ayant des première (32) et seconde (33) extrémités supportées au niveau d'emplacements espacés sur ladite section de base (13, 14, 17, 18), et ayant une partie centrale (36) disposée entre lesdites première (32) et seconde (33) extrémités de celle-ci, comprenant les étapes consistant à :
configurer ladite membrane (31) de façon qu'elle comprenne des première (41) et seconde (42) sections disposées sur des côtés opposés de ladite partie centrale (36), chacune desdites première (41) et seconde (42) sections s'étendant transversalement à ladite membrane (31) et ayant un profil approximativement en forme de U, ledit élément conducteur (22) étant positionné entre lesdites première (41) et seconde (42) sections ;
appliquer une tension entre ledit élément conducteur (22) et ladite partie centrale (36), la tension étant capable de :
fléchir de façon résiliente ladite membrane (31) de telle manière que ladite membrane (31) se déplace depuis une première position, dans laquelle ladite membrane (31) reste non fléchie et ladite partie centrale (36) est espacée dudit élément conducteur (22), jusqu'à une seconde position, dans laquelle ladite membrane (31) est fléchie et ladite partie centrale (36) est adjacente audit élément conducteur (22) en réponse à ladite tension ; et
amener lesdites première et seconde sections à venir en prise avec ladite section de base avant que ladite partie centrale (36) n'atteigne ladite position adjacente audit élément conducteur (22) lorsque ladite membrane (31) se déplace depuis ladite première position jusqu'à ladite seconde position.

14. Procédé selon la revendication 13, comprenant l'étape consistant à configurer chacune desdites première (41) et seconde (42) sections de façon qu'elles présentent un profil en U ayant la forme d'une demi-période d'une onde sinusoïdale.

15. Procédé selon la revendication 13, comprenant l'étape consistant à configurer chacune desdites première (41) et seconde (42) sections de façon que, lorsque ladite membrane (31) se trouve dans ladite première position, ledit profil en forme de U de celles-ci comprend des première (46) et seconde (47) parties espacées qui sont approximativement droites et s'étendent approximativement parallèlement l'une à l'autre, et ledit profil en forme de U comprend en outre une troisième partie (48) qui est approximativement droite et s'étend entre les extrémités desdites première (46) et seconde (47) parties approximativement perpendiculairement à celles-ci.

16. Procédé selon la revendication 15, comprenant l'étape consistant à amener chacune desdites première (46) et seconde (47) parties de chacune desdites première (41) et seconde (42) sections à s'incliner par rapport à ladite troisième partie (48) de celles-ci en réponse à l'application sur ladite membrane (31) d'une force parmi une force d'extension longitudinale et une force de contraction longitudinale.

17. Procédé selon la revendication 13, comprenant l'étape consistant à :
fléchir une partie centrale de ladite membrane (31) disposée entre lesdites première (41) et seconde (42) sections de celle-ci de façon à provoquer un déplacement de ladite partie centrale (36) jusqu'à ladite position adjacente audit élément conducteur (22).

18. Procédé selon la revendication 13, comprenant l'étape consistant à :
configurer ledit interrupteur de façon qu'il comprenne une couche diélectrique disposée au-dessus dudit élément conducteur, ladite partie centrale de ladite membrane venant en prise avec une face de ladite couche diélectrique à l'opposé dudit élément conducteur quand ladite membrane se trouve dans ladite seconde position.

19. Procédé selon la revendication 13, comprenant les étapes consistant à :
provoquer l'application de ladite tension appliquée entre ledit élément électriquement conducteur (22) et ladite partie centrale (36) en appliquant entre celles-ci une première tension qui provoque un déplacement de ladite membrane (31) depuis ladite première position jusqu'à ladite seconde position ; et
appliquer ensuite entre celles-ci une seconde tension qui est inférieure à ladite première tension et qui est suffisante pour maintenir ladite membrane (31) dans ladite seconde position de celle-ci.

20. Procédé de fabrication d'un interrupteur, comprenant les étapes consistant à :
former un élément électriquement conducteur (22) sur une section de base ;
former au-dessus dudit élément conducteur (22) une couche d'entretoise ayant une surface supérieure pourvue d'une partie qui définit une paire de rainures espacées vers l'extérieur de chaque extrémité de l'élément conducteur (22) par rapport au reste de ladite surface supérieure, ledit élément conducteur (22) étant positionné entre ladite paire de rainures ;
former au-dessus de ladite surface supérieure une couche de membrane électriquement conductrice (31) qui a des première (32) et seconde (33) extrémités venant en prise avec des parties espacées de ladite section de base, disposées sur des côtés opposés dudit élément conducteur (22), ladite couche de membrane (31) ayant une partie centrale (36) entre lesdites première et seconde extrémités, ladite couche de membrane (31) ayant des première (41) et seconde (42) sections disposées à l'intérieur de ladite paire de rainures sur des côtés opposés de ladite partie centrale (36), chacune desdites première (41) et seconde (42) sections s'étendant transversalement à ladite membrane (31) et ayant un profil approximativement en forme de U ; et
retirer ladite couche d'entretoise de façon à laisser ladite couche de membrane (31) supportée par lesdites extrémités de celle-ci, ladite partie centrale (36) étant espacée au-dessus dudit élément conducteur (22), ladite couche de membrane (31) étant apte à fléchir jusqu'à une première position dans laquelle les première (41) et seconde (42) sections viennent en prise avec ladite section de base avant que ladite partie centrale vienne en prise avec ledit élément conducteur (22).

21. Procédé selon la revendication 20, dans lequel ladite étape de formation de ladite couche d'entretoise est réalisée en formant une première partie de ladite couche d'entretoise au-dessus dudit élément conducteur, puis en formant des secondes parties de ladite couche d'entretoise, comprenant ladite paire de rainures, sur ladite première partie de celle-ci.

22. Procédé selon la revendication 20, comprenant l'étape de formation de ladite section de base en réalisant les étapes consistant à :
fournir un substrat (13) ;
former une couche d'oxyde (14) au-dessus dudit substrat (13) ;
former deux montants conducteurs espacés (17, 18) au niveau d'emplacements espacés sur ladite couche d'oxyde (14), lesdits montants (17, 18) étant lesdites parties espacées de ladite section de base, qui supportent lesdites première (32) et seconde (33) extrémités de ladite couche de membrane (31) ; et
réaliser ladite étape de formation dudit élément conducteur (22) en formant ledit élément conducteur (22) au niveau d'un emplacement entre lesdits montants (17, 18).
